Europäisches Patentamt

European Patent Office

Office européen des brevets

(19)

(11) Veröffentlichungsnummer: **0 222 161**
**A2**

(12) # EUROPÄISCHE PATENTANMELDUNG

(21) Anmeldenummer: 86113931.9

(22) Anmeldetag: 08.10.86

(51) Int. Cl.4: **G01R 27/26**

(30) Priorität: 10.10.85 CS 7256/85

(43) Veröffentlichungstag der Anmeldung:
**20.05.87 Patentblatt 87/21**

(84) Benannte Vertragsstaaten:
**BE CH DE FR GB IT LI NL SE**

(71) Anmelder: **CKD Praha oborovy podnik**
**U Kolbenky 159**
**Prag 9(CS)**

(72) Erfinder: **Gabas, Ivan, RNDr**
**Nerudova 7**
**Hostivic 1(CS)**
Erfinder: **Brajko, Stepan, Dipl.-Ing.**
**Konopistká 9**
**Praha 10(CS)**
Erfinder: **Zamastil, Jaroslav, RNDr.**
**Belgicka 20**
**Praha 2(CS)**

(74) Vertreter: **Patentanwälte Beetz sen. - Beetz**
**jun. Timpe - Siegfried - Schmitt-Fumian**
**Steinsdorfstrasse 10**
**D-8000 München 22(DE)**

(54) **Kapazitätsmessverfahren, Kapazitätsmessschaltung und Kapazitätsmessvorrichtung für sehr niedrige Frequenzen.**

(57) Die Erfindung betrifft ein Verfahren zur Kapazitätsmessung sowie eine Kapazitätsmeßschaltung und -vorrichtung für sehr niedrige Frequenzen im Bereich von 0 bis 0,1 Hz. Die Kapazitätsmeßschaltung bzw. -vorrichtung umfaßt eine elektromagnetisch abgeschirmte thermostatisierte Meßkammer (1) mit dem Prüfling (2), eine programmierbare Meßspannungsquelle (3), eine Überspannungsschutzschaltung (9), ein Integrationsglied (10), einen Ladungs-/Spannungs-Wandler (4), zwei elektrisch gesteuerte Schalter (11, 12), einen Analog-/Digital-Wandler (5), eine Steuereinheit (6), eine Eingangs-und Ausgangseinheit (7) und eine Synchronisationsimpulsquelle (8). Die Schaltung ist dabei so konzipiert, daß in aufeinanderfolgenden Arbeitszyklen der aus dem Integrationsglied (10), dem Ladungs-/Spannungs-Wandler (4) und den Schaltern (11, 12) gebildete Integrator periodisch genullt wird, mit abgeschaltetem Eingang integriert, erneut genullt wird und mit angeschlossenem Eingang integriert, was eine durchgehende Messung und Eliminierung des Eingangsstroms des Ladungs-/Spannungs-Wandlers (4) erlaubt, wobei jeweils der Analog-/Digital-Wandler (5) zusammen mit der Steuereinheit (6) die A/D-Wandlung der Meßwerte durchführt und auch schnelle Übergangseffekte bei der Ladung und Entladung der gemessenen Kapazität erfaßt werden können.

## Kapazitätsmeßverfahren, Kapazitätsmeßschaltung und Kapazitätsmeßvorrichtung für sehr niedrige Frequenzen

Die Erfindung betrifft eine Kapazitätsmeßschaltung für sehr niedrige Frequenzen im 0-bis 0,1-Hz-Band, d.h. für Periodendauern T größer oder gleich 10 s, sowie eine entsprechende Kapazitätsmeßvorrichtung sowie das zugrundeliegende Kapazitätsmeßverfahren.

Kapazitätsmessungen und von ihnen abgeleitete Dielektrizitätskonstanten von Kondensatoren im Frequenzbereich von 0 bis 0,1 Hz, d.h. mit einer Periodendauer T größer oder gleich 10 s, sind eine unerläßliche Bedingung bei einigen speziellen Anwendungen von Dielektrika, wie z.B. beim Oberflächenschutz der Facette von Leistungshalbleitersystemen. Die Messung hochwertiger dielektrischer Materialien erfordert dabei eine Stromintegration im pA-bis fA-Bereich und die Messung schneller Übergangserscheinungen mit Strömen im Bereich bis zu einigen Hundert mA bei hohen Temperaturen. Derartige Messungen sind mit Problemen verbunden, die durch ein störendes äußeres elektrostatisches und/oder elektromagnetisches Feld, z. B. durch die Beheizung des gemessenen Prüflings, Felder in Industriebetrieben etc. verursacht werden.

Mangels anderer verfügbarer Meßgeräte wird bislang das Verfahren der numerischen Integration von Lade-und Entladeströmen mit zeitlicher Extrapolation unter Verwendung von Niederstrom-Meßgeräten angewandt. Dieses Verfahren ist sehr arbeitsintensiv und darüber hinaus mit einem bedeutenden Fehler (bis 50 %) behaftet, der durch die zeitliche Extrapolation der Meßwerte und der Störung der Meßschaltung durch äußere Magnetfelder bedingt ist. Es wäre zwar prinzipiell möglich, dieses Verfahren durch Verwendung hochwertiger Meßgeräte für kleine Ströme und Ladungen zu verbessern, die über einen Bus vom Typ IEEE-488 an einen Prozeßrechner angeschlossen sind. Auch diese mit hohen Kosten verbundene Verbesserung ermöglicht jedoch weder ein genaues Erfassen schneller Übergangserscheinungen mit Impulsladung und -entladung des Prüflings noch eine genügend genaue Meßzyklussynchronisation mit der Netzstörspannung im Hinblick auf die Architektur und das Betriebssystem kommerziell zugänglicher Prozeßrechner mit einem Interface vom Typ IEEE-488.

Der Erfindung liegt die Aufgabe zugrunde, ein Kapazitätsmeßverfahren, eine Kapazitätsmeßschaltung sowie eine entsprechende Kapazitätsmeßvorrichtung für sehr niedrige Frequenzen anzugeben, bei denen die oben erläuterten Nachteile des Standes der Technik nicht auftreten.

Die Aufgabe wird gemäß den Ansprüchen 1 bis 3 gelöst.

Die erfindungsgemäße Kapazitätsmeßschaltung für sehr niedrige Frequenzen im 0-bis 0,1-Hz-Band umfaßt eine programmierbare Meßspannungsquelle, eine Überspannungsschutzschaltung, ein Integrationsglied, einen Ladungs-/Spannungs-Wandler, zwei elektrisch gesteuerte Schalter, einen Analog-/Digital-Wandler, eine Steuereinheit, eine Eingangs-und Ausgangseinheit und eine Synchronisationsimpulsquelle, und ist dadurch gekennzeichnet, daß der Ausgang der programmierbaren Meßspannungsquelle mit dem ersten Anschluß des Prüflings verbindbar ist, der sich in einer elektromagnetisch abgeschirmten thermostatisierten Meßkammer befindet, der Eingang der Überspannungsschutzschaltung mit dem zweiten Anschluß des Prüflings verbindbar ist, der Ausgang der Überspannungsschutzschaltung mit dem Eingang des Integrationsgliedes verbunden ist, dessen Ausgang mit dem Eingang des ersten elektrisch gesteuerten Schalters verbunden ist, dessen Ausgang mit dem Ausgang des zweiten elektrisch gesteuerten Schalters und gleichzeitig mit dem Eingang des Ladungs-/Spannungs-Wandlers verbunden ist, dessen Ausgang mit dem Eingang des zweiten elektrisch gesteuerten Schalters und mit dem Analogeingang des Analog-/Digital-Wandlers verbunden ist, wobei der Ausgang der Synchronisationsimpulsquelle mit dem Unterbrechungseingang der Steuereinheit verbunden ist, deren erster Ausgang mit dem Betätigungseingang des ersten elektrisch gesteuerten Schalters, deren zweiter Ausgang mit dem Betätigungseingang der programmierbaren Meßspannungsquelle und deren dritter Ausgang mit dem Steuereingang des zweiten elektrisch gesteuerten Schalters verbunden sind, und der erste Eingang/Ausgang der Steuereinheit mit dem Eingang/Ausgang des Analog-/Digital-Wandlers und ihr zweiter Eingang/Ausgang mit dem Eingang/Ausgang der Eingangs-und Ausgangseinheit verbunden sind.

Die erfindungsgemäße Kapazitätsmeßvorrichtung ist gekennzeichnet durch eine elektromagnetisch abgeschirmte Meßkammer für den Prüfling und eine daran angeschlossene Kapazitätsmeßschaltung wie oben definiert.

Das Verfahren gemäß der Erfindung zur Kapazitätsmessung von Dielektrika im Frequenzbereich von 0 bis 0,1 Hz ist entsprechend gekennzeichnet durch Verwendung der oben definierten Kapazitätsmeßschaltung bzw. Kapazitätsmeßvorrichtung.

Die erfindungsgemäße Kapazitätsschaltung für sehr niedrige Frequenzen im Bereich von 0 bis 0,1 Hz erlaubt die Erzielung einer um Größenordnungen höheren Meßgenauigkeit bei der Messung der Dielektrizitätskonstante im Bereich sehr niedriger Frequenzen. Sie ermöglicht durch genaue Synchronisation des Meßzyklus mit der Netzfrequenz sowie durch Anschluß des abgeschirmten Prüflings durch beliebig lange, abgeschirmte Kabel den Einfluß störender äußerer elektromagnetischer und elektrostatischer Felder zu eliminieren.

Die Schaltung ermöglicht ferner, den Einfluß des Eingangsstroms des Eingangsverstärkers des Analogteils durch geeignete Zeitstaffelung des Arbeitszyklus des genullten Integrators um mehrere Größenordnungen zu unterdrücken.

Besonders vorteilhaft ist ferner, daß auch - schnelle Übergangserscheinungen bei der Ladung und Entladung der gemessenen Kapazität, z. B. eines Kondensators, erfaßt werden können, wobei zugleich eine zeitliche Extrapolation entfällt. Gleichzeitig ermöglicht die erfindungsgemäße Kapazitätsmeßschaltung eine vollständige Automatisierung des gesamten Meßzyklus, wodurch wiederum durch Bedienung verursachte Fehler und Ungenauigkeiten eliminiert werden.

Die erfindungsgemäße Vorrichtung kann ferner als kleines kompaktes Gerät ausgeführt werden, dessen Gestehungskosten niedrig sind.

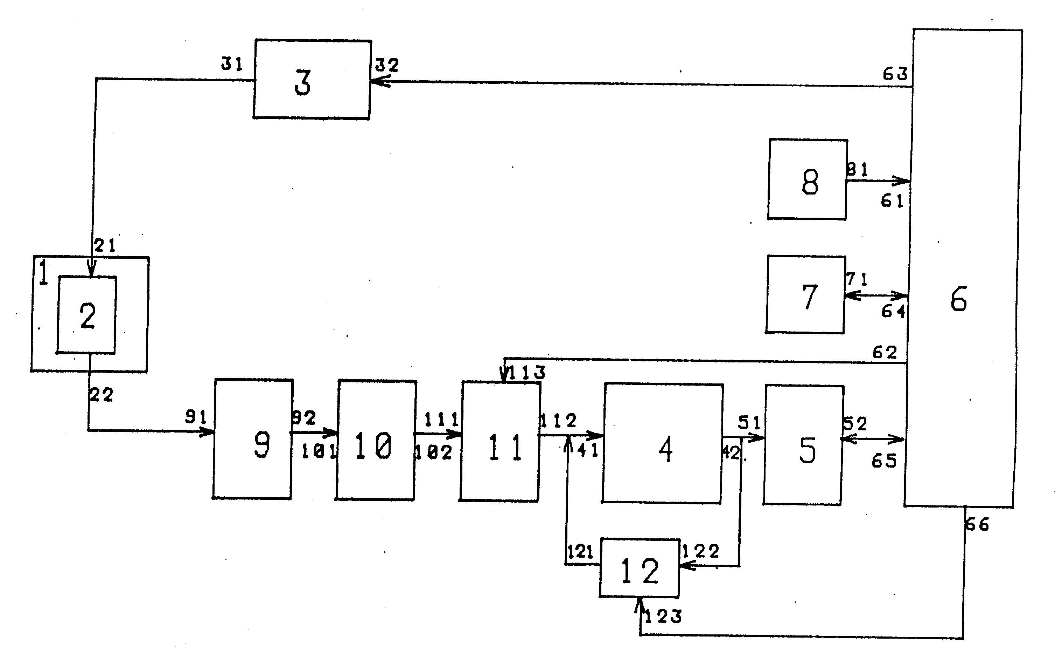

Ein Beispiel der erfindungsgemäßen Kapazitätsmeßschaltung für sehr niedrige Frequenzen im 0-bis 0,1-Hz-Band bzw. einer entsprechenden Kapazitätsmeßvorrichtung wird im folgenden anhand der Zeichnung näher erläutert.

In der elektromagnetisch abgeschirmten thermostatisierten Meßkammer 1 befindet sich der Prüfling 2, dessen erster Anschluß 21 mit dem Ausgang 31 der programmierbaren Meßspannungsquelle 3 und dessen zweiter Anschluß 22 mit dem Eingang 91 der Überspannungsschutzschaltung 9 verbunden ist, deren Ausgang 92 mit dem Eingang 101 des Integrationsglieds 10 verbunden ist. Der Ausgang 102 des Integrationsglieds 10 ist mit dem Eingang 111 des ersten elektrisch gesteuerten Schalters 11 verbunden, dessen Ausgang 112 mit dem Ausgang 121 des zweiten elektrisch gesteuerten Schalters 12 und gleichzeitig mit dem Eingang 41 des Ladungs-/Spannungs-Wandlers 4 verbunden ist, dessen Ausgang 42 mit dem Eingang 122 des zweiten elektrisch gesteuerten Schalters 12 und mit dem Analogeingang 51 des Analog-/Digital-Wandlers 5 verbunden ist, dessen Eingang/Ausgang 52 mit dem ersten Eingang/Ausgang 65 der Steuereinheit 6 verbunden ist. Der zweite Eingang/Ausgang 64 der Steuereinheit 6 ist mit dem Eingang/Ausgang 71 der Eingangs-und Ausgangseinheit 7 verbunden. Der Ausgang 81 der Synchronisationsimpulsquelle 8 ist mit dem Unterbrechungseingang 61 der Steuereinheit 6 verbunden, deren erster Ausgang 62 mit dem Betätigungseingang 113 des ersten elektrisch gesteuerten Schalters 11 und deren zweiter Ausgang 63 mit dem Betätigungseingang 32 der programmierbaren Meßspannungsquelle 3 und deren dritter Ausgang 66 mit dem Steuereingang 123 des zweiten elektrisch gesteuerten Schalters 12 verbunden sind.

Die erfindungsgemäße Kapazitätsmeßschaltung bzw. -vorrichtung für sehr niedrige Frequenzen im 0-bis 0,1-Hz-Band arbeitet so, daß der Prüfling 2 von der an seinen ersten Anschluß 21 angeschlossenen Hochspannungsquelle 3 kommenden Spannung geladen/entladen wird. Der zweite Anschluß 22 des Prüflings 2 wird durch das Integrationsglied 10 und den Eingang 41 des Ladungs-/Spannungs-Wandlers 4 über den ersten elektrisch gesteuerten Schalter 11 auf virtuellem Nullpotential gehalten. Das Integrationsglied 10 und der Eingang 41 des Ladungs-/Spannungs-Wandlers 4 sind durch die Überspannungsschutzschaltung 9 gegen Überlastspannung geschützt. Dies ermöglicht den Anschluß des Prüflings 2 durch ein abgeschirmtes Kabel ohne störende Beeinflussung durch die Kapazität dieses Kabels. Die Zeitstaffelung der Arbeitszyklen des vom Integrationsglied 10, dem Ladungs-/Spannungs-Wandler 4 und den elektrisch gesteuerten Schaltern 11, 12 gebildeten automatisch genullten Integrators wurde so gewählt, daß der Integrator genullt wird, worauf er mit dem abgeschalteten Eingang integriert, wonach er erneut genullt und dann mit dem angeschlossenen Eingang integriert wird. Dieser gesamte Zyklus wird periodisch wiederholt. Dies ermöglicht, den Eingangsstrom des Ladungs-/Spannungs-Wandlers 4 durchgehend zu messen und zu eliminieren. Der Analog-/Digital-Wandler 5 führt dann in Zusammenarbeit mit der Steuereinheit 6 die Analog-/Digital-Wandlung der Meßwerte durch. Die Steuereinheit 6 steuert den Arbeitszyklus der gesamten Meßvorrichtung, betätigt die programmierbare Meßspannungsquelle 3, steuert den Arbeitszyklus des Integrators und des Analog-/Digital-Wandlers 5 und steht über die Eingangs-und Ausgangseinheit 7 mit externen Systemen etc. in Verbindung. Die Arbeitszyklussteuerung wird direkt von der Synchronisationsimpulsquelle 8 abgeleitet, wobei die Synchronisationsimpulse beim Nulldurchgang der Netzspannung erzeugt werden. Die genaue Meßzyklussynchronisation wird durch ein schnelles Prgrammsegment gesichert, das durch eine vom Synchronisationsimpuls abgeleitete nichtmaskierbare Unterbrechung mit höchster Priorität in Gang gesetzt wird.

Als Integrationsglied 10 kann beispielsweise ein gegen Erde geschalteter hochwertiger Kondensator verwendet werden, dessen Kapazität 100- bis 1000mal größer ist als die Kapazität des Prüflings 2; als Steuereinheit 6 kann beispielsweise ein Einplatinen-Mikrocomputer verwendet werden, z.B. auf der Basis eines Z80-Mikroprozessors. Der Analog-/Digital-Wandler 5 kann beispielsweise durch ein Digitalvoltmeter realisiert sein; dann ist der Ladungs-/Spannungs-Wandler 4 ein Integrator - (Ladungspumpe). Alternativ kann der Analog-/Digital-Wandler 5 ein Spannungskomparator sein, wobei dann der Ladungs-/Spannungs-Wandler 4 von einem Integrator mit einer Referenzspannungsquelle und einem von der Steuereinheit 6 gesteuerten Umschalter der Referenzmeßspannung gebildet ist.

**Ansprüche**

1. Kapazitätsmeßschaltung für sehr niedrige Frequenzen im 0- bis 0,1-Hz-Band
mit
einer programmierbaren Meßspannungsquelle (3), einer Überspannungsschutzschaltung (9), einem Integrationsglied (10), einem Ladungs-/Spannungs-Wandler (4), zwei elektrisch gesteuerten Schaltern - (11, 12) einem Analog-/Digital-Wandler (5) einer Steuereinheit (6), einer Eingangs-und Ausgangseinheit (7) und einer Synchronisationsimpulsquelle (8),
**dadurch gekennzeichnet, daß**
der Ausgang (31) der programmierbaren Meßspannungsquelle (3) mit dem ersten Anschluß - (21) des Prüflings (2) verbindbar ist, der sich in einer elektromagnetisch abgeschirmten thermostatisierten Meßkammer (1) befindet, der Eingang - (91) der Überspannungsschutzschaltung (9) mit dem zweiten Anschluß (22) des Prüflings (2) verbindbar ist,
der Ausgang (92) der Überspannungsschutschaltung (9) mit dem Eingang (101) des Integrationsgliedes (10) verbunden ist,
dessen Ausgang (102) mit dem Eingang (111) des ersten elektrisch gesteuerten Schalters (11) verbunden ist,
dessen Ausgang (112) mit dem Ausgang (121) des zweiten elektrisch gesteuerten Schalters (12) und gleichzeitig mit dem Eingang (41) des Ladungs-/Spannungs-Wandlers (4) verbunden ist,
dessen Ausgang (42) mit dem Eingang (122) des zweiten elektrisch gesteuerten Schalters (12) und mit dem Analogeingang (51) des Analog-/Digital-Wandlers (5) verbunden ist,
wobei der Ausgang (81) der Synchronisationsimpulsquelle (8) mit dem Unterbrechungseingang - (61) der Steuereinheit (6) verbunden ist,
deren erster Ausgang (62) mit dem Betätigungseingang (113) des ersten elektrisch gesteuerten Schalters (11), deren zweiter Ausgang - (63) mit dem Betätigungseingang (32) der programmierbaren Meßspannungsquelle (3) und deren dritter Ausgang (66) mit dem Steuereingang (123) des zweiten elektrisch gesteuerten Schalters (12) verbunden sind,
und der erste Eingang/Ausgang (65) der Steuereinheit (6) mit dem Eingang/Ausgang (52) des Analog-/Digital-Wandlers (5) und ihr zweiter Eingang/Ausgang (64) mit dem Eingang/Ausgang - (71) der Eingangs-und Ausgangseinheit (7) verbunden sind.

2. Kapazitätsmeßvorrichtung, gekennzeichnet durch eine elektromagnetisch abgeschirmte Meßkammer (1) für den Prüfling (2) und eine daran angeschlossene Kapazitätsmeßschaltung nach Anspruch 1.

3. Verfahren zur Kapazitätsmessung von Dielektrika im Frequenzbereich von 0 bis 0,1 Hz, gekennzeichnet durch Verwendung einer Kapazitätsmeßschaltung nach Anspruch 1 bzw. einer Kapazitätsmeßvorrichtung nach Anspruch 2.

0 222 161